# EUROPEAN PATENT SPECIFICATION

(11) **EP 1 103 345 B1**
(45) Date of publication and mention of the grant of the patent: **14.05.2008**
(21) Application number: 00310348.8
(22) Date of filing: 22.11.2000
(51) Int. Cl.: B24B 37/04, B24B 53/007, B08B 3/02

(54) **Polishing machine**
Poliermaschine
Machine de polissage

(30) Priority: 25.11.1999 JP 33463199
(43) Date of publication of application: 30.05.2001
(73) Proprietor: Fujikoshi Machinery Corporation, Nagano-shi, Nagano 381-1233 (JP)
(72) Inventor: Nishimoto, Yoshinobu, Nagano-shi, Nagano (JP); Nakajima, Makoto, Nagano-shi, Nagano (JP); Nakamura, Yoshio, Nagano-shi, Nagano (JP); Denda, Yasuhide, Nagano-shi, Nagano (JP); Miyagawa, Chihiro, Nagano-shi, Nagano (JP)
(74) Representative: Paget, Hugh Charles Edward

(56) References cited:
- WO-A-98/06540
- US-A- 2 870 580
- US-A- 5 421 768
- PATENT ABSTRACTS OF JAPAN vol. 015, no. 120 (M-1096), 25 March 1991 (1991-03-25) -& JP 03 010769 A (MITSUBISHI METAL CORP;OTHERS: 01), 18 January 1991 (1991-01-18)

## Description

The present invention relates to a polishing machine having a cloth cleaning device.

A surface of a semiconductor wafer must be precisely polished like a mirror face with uniform thickness before integrated circuits are formed thereon.

Many types of polishing machines have been used to polish semiconductor wafers, etc..

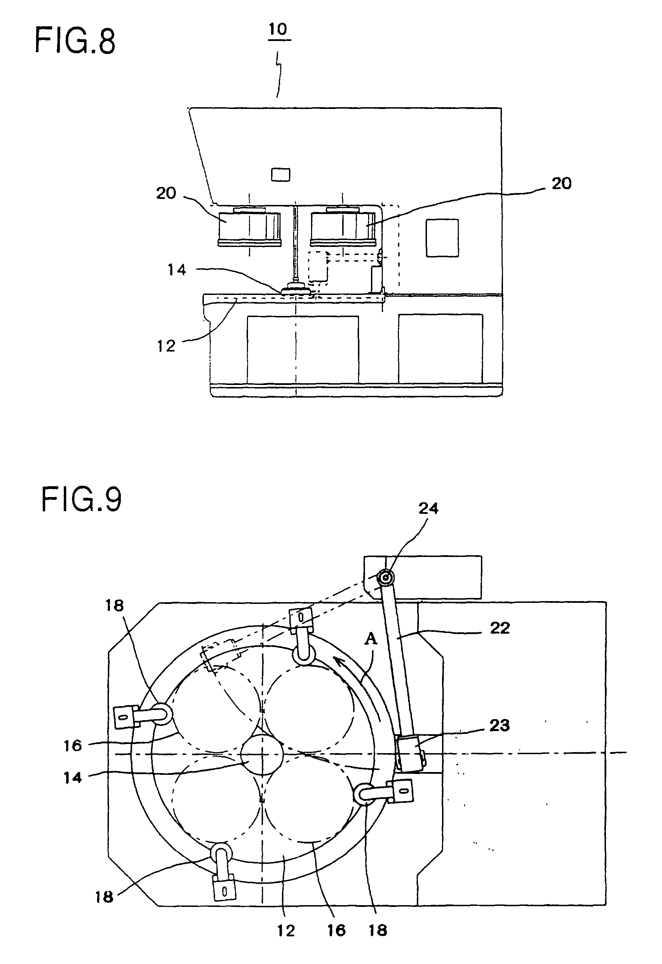

One of the conventional polishing machines is shown in Figs. 8 and 9. The polishing machine 10 has a polishing plate 12, whose upper face is covered with a polishing cloth and which is rotated in a horizontal plane. A center roller 14, which is capable of rotating freely, is provided at a center of the polishing plate 12. A plurality of work plates 16 are provided on the polishing cloth. Work pieces 17 to be polished, e.g., semiconductor wafers, are adhered on a bottom face of each work plate 16, and their bottom faces contact the polishing cloth.

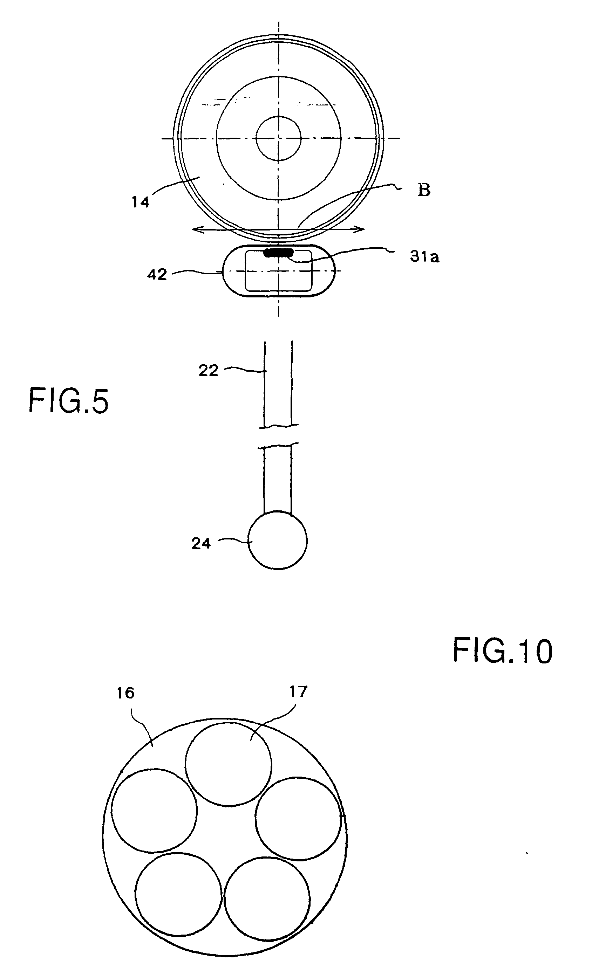

Fig. 10 shows a state in which the semiconductor wafers 17 are adhered on the work plate 16. Guide rollers 18 are provided in the vicinity of an outer edge of the polishing plate 12 as shown in Fig. 9, and outer circumferential faces of the work plates 16 contact the center roller 14 and the guide rollers 18. The polishing plate 12 is rotated in a direction of an arrow "A", but the work plates 16 are held at predetermined positions by the center roller 14 and the guide rollers 18.

As shown in Fig. 9, the guide rollers 18 are vertically moved by an elevating mechanism, and their strokes of vertical movement are equal to or more than thickness of the work plates 16. When the guide rollers 18 are at the lowest positions, they are located close to the outer edge of the polishing plate 12 so as to contact the outer circumferential face of the work plates 16; when the guide rollers 18 are at the highest positions, they are moved away from the outer edge of the polishing plate 12 so as to allow the work plates 16 to pass through a space between the center roller 14 and the guide rollers 18 with the rotation of the polishing plate 12.

Note that, the guide rollers 18 may be moved between positions close to the outer edge of the polishing plate 12 and positions away therefrom by, for example, swinging arms of the guide rollers 18. The moving mechanism of the guide rollers 18 is not always necessary. In some cases, the guide rollers 18 may be fixed at predetermined positions or no guide rollers 18 are required.

Press heads 20 are vertically moved. When the press heads 20 are at the lowest positions, the press heads 20 respectively press the work plates 16 and the semiconductor wafers onto the polishing cloth with proper force. Therefore, the bottom faces of the semiconductor wafers can be polished by the polishing cloth, which is rotated together with the polishing plate 12.

Note that, the press heads 20 can be freely rotated about their axes.

While polishing the semiconductor wafers, alkaline slurry including abrasive grains, e.g., silica grains, and is fed to the polishing cloth rotating. Therefore, the bottom faces of the semiconductor wafers can be mechanically and chemically polished like mirror faces.

A holding member 23 is provided to a front end of an arm 22 for cleaning. Brush (not shown), which is capable of brushing the surface of the polishing cloth, is provided on a bottom face of the holding member 23.

The arm 22 is capable of swinging or rotating about a rotary shaft 24, which is located outside of the polishing plate 12. While the semiconductor wafers are polished, the arm 22 is located outside of the polishing plate 12; while the polishing cloth is cleaned, the arm 22 is swung, about the rotary shaft, above the polishing plate 12.

While the polishing cloth is cleaned, wash water is caused to flow radially, from the center roller 14, onto the polishing cloth.

The polishing cloth must be cleaned because abraded grains, which are formed by abrading the semiconductor wafers, and reaction products gradually permeate and deposit in the polishing cloth, so that polishing efficiency of the polishing cloth must be lower.

However, in the conventional polishing machine, the polishing cloth is cleaned by merely supplying the wash water from the center roller 14 and brushing. So the polishing cloth cannot be fully cleaned, and the polishing efficiency of the polishing cloth cannot be recovered. Further, the holding member 23 must have a prescribed width, so the holding member 23 must be moved backward from the center roller 14 so as not to collide with the center roller 14 when the arm 22 is swung, so that a part of the polishing cloth in the vicinity of the outer circumferential face of the center roller 14 cannot be cleaned well.

It would be desirable to be able to provide a cloth cleaning device and a polishing machine, which are capable of fully cleaning a polishing cloth including a part in the vicinity of a center roller.

According to the present invention there is provided a polishing machine, comprising:
a polishing plate whose upper face is covered with a polishing cloth;
a driving mechanism for rotating the polishing plate;
a center roller at the center of the polishing plate;
a work plate, on which, in use, a work piece to be polished is adhered and whose outer circumferential face contacts an outer circumferential face of the center roller, said work plate disposed relative to the polishing cloth so as to make the work piece contact the polishing cloth;
a press head for pressing the work plate onto the polishing cloth;
a slurry feeding mechanism for feeding slurry to the polishing cloth
an arm which is movable, in a plane parallel to the polishing cloth, between a first position, which is located above the polishing cloth, and a second position, which is located outside of the polishing cloth;
a jet nozzle attached to the arm for jetting high pressure water toward the polishing cloth; and
an enclosing member enclosing the jet nozzle so as to prevent the high pressure water, which has been jetted out from the jet nozzle, from scattering,
wherein the jet nozzle is disposed or disposable at an angle to the vertical and, when the arm is in its first position, the jet nozzle is close to the centre roller, and the angling of the jet nozzle enables high pressure water to be jetted toward a part of the polishing cloth in the vicinity of the center roller.

The polishing machine may further comprise a guide roller being provided in the vicinity of an outer edge of the polishing plate, and an outer circumferential face of the work plate may contact outer circumferential faces of the center roller and the guide roller.

In the present invention, an angle of the jet nozzle may be changed between a first angle, which is said angle to the vertical, and a second angle, at which the jet nozzle is vertical.

A sectional shape of a jet form of the high pressure water may be longer in the direction of moving the arm.

The enclosing member may be a plastic net enclosing the jet nozzle.

In the polishing machine of the present invention, the polishing cloth including the part in the vicinity of the center roller can be fully cleaned, so that the work piece can be precisely polished with higher polishing efficiency and span of life of the expensive polishing cloth can be made longer.

Embodiments of the present invention will now be described by way of examples and with reference to the accompanying drawings, in which:
Fig. 1 is an explanation view of a first embodiment of the polishing machine of the present invention;
Fig. 2 is an enlarged view in the vicinity of a jet nozzle;
Fig. 3 is a perspective view of a plastic net, which acts as an enclosing member;
Fig. 4 is an explanation view of the plastic net;
Fig. 5 is an explanation view showing a sectional shape of a jet form of high pressure water;
Fig. 6 is a perspective view of a plastic net of a second embodiment;
Fig. 7 is a perspective view of a plastic net of a third embodiment;
Fig. 8 is an explanation view showing the outline of the conventional polishing machine;
Fig. 9 is a plan view of the polishing plate of the conventional polishing machine; and
Fig. 10 is an explanation view of the work plate, on which the semiconductor wafers are adhered.

Preferred embodiments of the present invention will now be described in detail with reference to the accompanying drawings.

Basic structures of the polishing machines of the present embodiments are equal to that of the conventional polishing machine shown in Figs. 8-10, so the elements explained above are assigned the same symbols and explanation will be omitted.

The polishing machine 10 includes: the polishing plate 12, whose upper surface is covered with the polishing cloth 12a; a driving mechanism (e.g., a motor) for rotating the polishing plate 12; the center roller 14 being provided at the center of the polishing plate 12; the work plates 16, on each of which work pieces (e.g., semiconductor wafers) to be polished are adhered and whose outer circumferential faces contact the outer circumferential face of the center roller 14, being provided on the polishing cloth 12a so as to make the work pieces contact the polishing cloth 12a; the press heads 20 for pressing the work plates 16 onto the polishing cloth 12a; a slurry feeding mechanism 15 for feeding alkaline slurry to the polishing cloth 12a; and a cloth cleaning device 30. The cloth cleaning device 30 comprises: an arm 22 being swung or rotated, about the rotary shaft 24, in a plane parallel to the polishing cloth 12a, between a first position, which is located above the polishing cloth 12a, and a second position, which is located outside of the polishing cloth 12a; a jet nozzle 31 being attached to the arm 22 and jetting high pressure water toward the polishing cloth 12a; and an enclosing member 40 enclosing the jet nozzle 31 so as to prevent the high pressure water, which has been jetted out from the jet nozzle 31, from scattering. The jet nozzle 31 is headed toward the center roller 14, and the high pressure water is jetted toward a part of the polishing cloth 12a in the vicinity of the center roller 14 when the arm 12 moves the jet nozzle 31 close to the center roller 14.

And, the polishing machine may comprises: the polishing plate 12, whose upper surface is covered with the polishing cloth 12a; the driving mechanism for rotating the polishing plate 12; the center roller 14 being provided at the center of the polishing plate 12; the work plates 16, on each of which the work pieces are adhered and whose outer circumferential faces contact the outer circumferential face of the center roller 14, being provided on the polishing cloth 12a so as to make the work pieces contact the polishing cloth 12a; the press heads 20 for pressing the work plates 16 onto the polishing cloth 12a; the slurry feeding mechanism 15 for feeding slurry to the polishing cloth 12a; the arm 22 being swung or rotated, about the rotary shaft 24, in a plane parallel to the polishing cloth 12a, between the first position above the polishing cloth 12a and a second position outside of the polishing cloth 12; the jet nozzle 31 being attached to the arm 22 and jetting high pressure water toward the polishing cloth 12a; and the enclosing member 40 enclosing the jet nozzle 31 so as to prevent the high pressure water from scattering, wherein the jet nozzle 31 is headed toward the center roller 14, and the high pressure water is jetted toward a part of the polishing cloth 12a in the vicinity of the center roller 14 when the arm 12 moves the jet nozzle 31 close to the center roller 14.

In each of the examples, the guide rollers 18 are provided in the vicinity of the outer edge of the polishing plate 12, and the outer circumferential faces of the work plates 16 contact the center roller 14 and the guide rollers 18.

As described above, the characteristic point of the present invention is the cloth cleaning device 30 and the polishing machine including the cloth cleaning means.

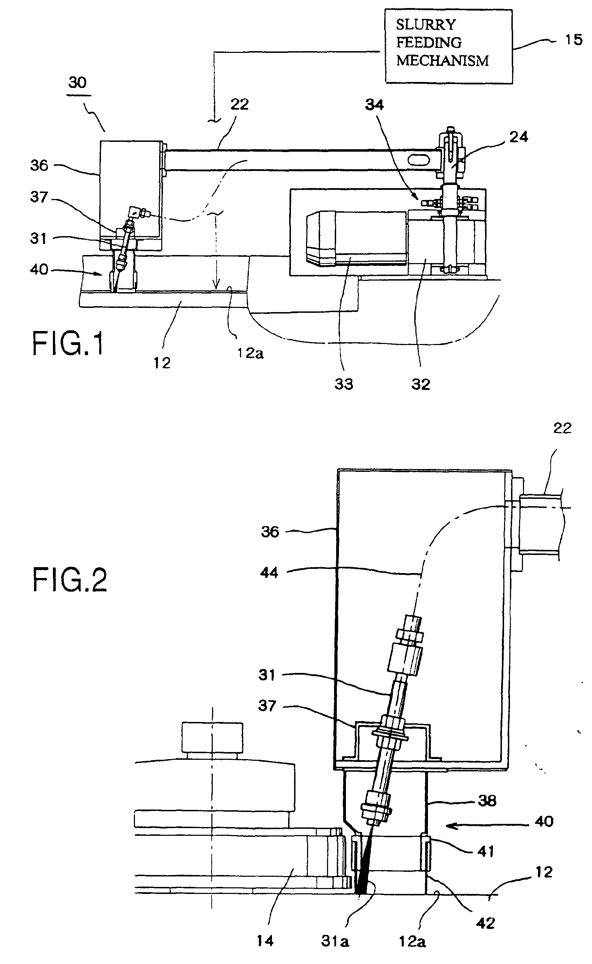

Fig. 1 shows the arm 22 and the jet nozzle 31 of the cloth cleaning device 30 of a first embodiment.

A base end of the arm 22 is fixed to the rotary shaft 24, and the arm 22 is swung or rotated in the plane parallel to the polishing cloth 12a. With this structure, a front end of the arm 22 can be moved between the first position above the polishing plate 12 and the second position outside thereof.

The rotary shaft 24 is rotated by the motor 33, which includes a reduction unit 32.

A sensor 34 detects rotational angle of the rotary shaft 24, so that rotational angle of the arm 22 can be known.

A holder box 36 is fixed to the front end of the arm 22. The jet nozzle 31 is diagonally pierced through the holder box 36 and fixed to the holder box 36 by a fixing member 37.

A cylindrical hood 38, which covers a side of the jet nozzle 31, is fixed to a bottom face of the holder box 36. Further, the enclosing member 40, which encloses sides of the water jet of the high pressure water, prevents the high pressure water from scattering, is fixed to the hood 38.

The enclosing member 40 includes: a cylindrical holding member 41 being fixed to a lower end of the hood 38; and cylindrical plastic nets 42, each of which is formed, for example, like screen, being fixed to the holding member 41.

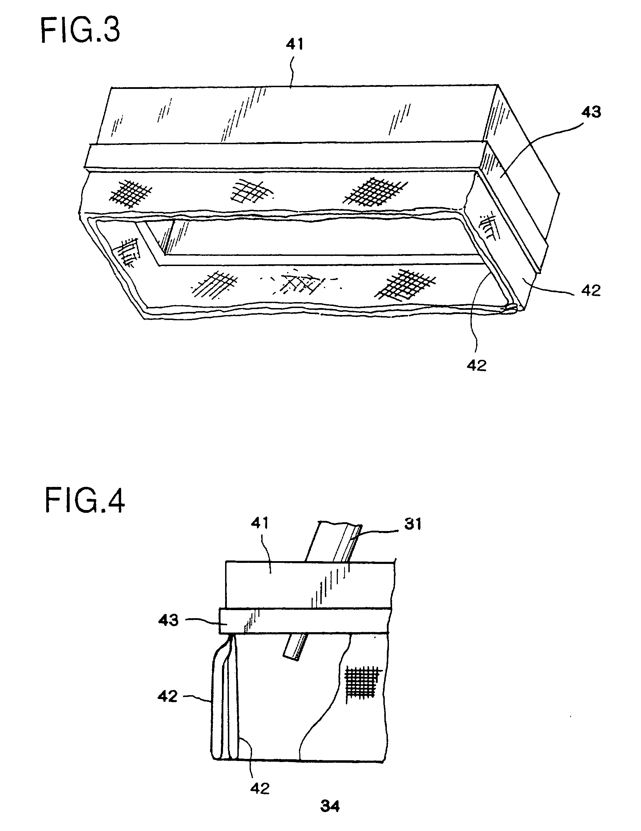

In the first embodiment, as shown in Figs. 3 and 4, a pair of the plastic nets 42, each of which is folded and a folding line makes a lower edge, are piled. The piled plastic nets 42 are sandwiched and fixed, by bolts (not shown), between the holding member 41 and a frame-shaped member 43. With this structure, the plastic nets 42 constitute a four-net-structure.

Mesh size of each plastic net 42 is about 1 mm, and thickness thereof is 0.5 mm. Therefore, the plastic nets 42, which constitute the four-net-structure, have enough flexibility.

The mesh size and hardness of the plastic nets 42 may be optionally designed. Further, the plastic nets 42 are not limited to the four-net-structure, so other structures (e.g., two-net-structure, six-net-structure) may be employed.

The jet nozzle 31 is diagonally provided. Namely, a lower end of the jet nozzle 31 is headed toward the center roller 14 when the arm 22 is located on a line connecting the rotary shaft 24 and the center roller 14, so that the high pressure water, which is diagonally jetted out from the jet nozzle 31, can be jetted toward the polishing cloth 12a in the vicinity of the outer edge of the center roller 14.

As clearly shown in Fig. 2, when the arm 22 is located at said position, the plastic nets 42 are very close to the outer circumferential face of the center roller 14 and the high pressure water 31a is jetted toward the lower end of an inner face of the plastic nets 42, which is on the center roller 14 side. In the first embodiment, the jetted water 31a reaches a position 7 mm away from the outer edge of the center roller 14.

The high pressure water is supplied to the jet nozzle 31 via a pressure-resisting hose 44. The pressure of the high pressure water [e.g., 30 kg/cm² (2.94Mpa) or more] may be optionally set.

Action of the polishing machine will be explained.

When the polishing cloth 12a is cleaned, the guide rollers 18 are moved upward and the arm 22 is swung by the motor 33. The rotational angle of the arm 22 is detected by the sensor 34, which detects the rotational angle of the rotary shaft 24, so that the swing movement of the arm 22 can be controlled so as not to move the jet nozzle 31 away from the polishing cloth 12a.

A pump (not shown) is driven to supply the high pressure water, and the high pressure water 31a is jetted from the jet nozzle 31 toward the polishing cloth 12a, so that abraded grains and reaction products, which have been deposited in the polishing cloth 12a, are washed away by the high pressure water 31a. The water including the grains and the reaction products is introduced onto the polishing cloth 12a via meshes of the plastic nets 42 and a gap between the lower ends of the plastic nets 42 and the polishing cloth 12a. Further, the grains and the reaction products are introduced outside of the polishing cloth 12a by water, which is radially flowed out from the center roller 14. With this action, the grains and the reaction products, which have been deposited in the polishing cloth 12a, can be removed from the polishing cloth 12a, so that the polishing cloth 12a can be recovered and reused with high polishing efficiency.

Since the plastic nets 42 has the four-net-structure, the pressure of the high pressure water 31a is decreased and the water 31a is discharged together with the reaction products, etc., so that the water 31a including the reaction products, etc. cannot be scattered to the periphery. The periphery can be kept clean.

As described above, the structure of the plastic nets 42 is not limited. Namely, any structures, which are capable of preventing the high pressure water 31 a from scattering in the periphery, can be employed as the enclosing member 40. The structure may be optionally changed according to conditions.

In the first embodiment, the plastic nets 42 are folded along the lower ends. The lower ends may be welded in the circumferential direction. With proper welding width, raveling plastic strings of the plastic nets 42 can be prevented even if the lower ends of the plastic nets 42 are abraded, so that span of life of the plastic nets 42 can be longer.

As described above, when the arm 22 is located on the line connecting the rotary shaft 24 and the center roller 14, the plastic nets 42 are very close to the outer circumferential face of the center roller 14 and the high pressure water 31a are jetted from the jet nozzle 31, which is diagonally provided to head for the center roller 14, toward the lower end of the inner face of the plastic nets 42, so that the polishing cloth 12a including the part in the vicinity of the center roller 14 can be fully cleaned.

As described above, the outer circumferential faces of the work plates 16 contact the outer circumferential face of the center roller 14. Outer edges of the work pieces, e.g., semiconductor wafers 17, are 7 mm separated away from the outer edge of the work plate 16, so that they are about 7 mm separated away from the outer circuferential face of the center roller 14. Therefore, the part of the polishing cloth 12a, which is 7 mm away from the outer circuferential face of the center roller 14, polishes the bottom faces of the semiconductor wafers 17. With this action, the abraded grains and the reaction products deposit in the part of the polishing cloth 12a, which is close to the outer edge of the center roller 14, but the conventional means cannot fully remove the abraded grains, etc. from said part of the polishing cloth 12a.

In the first embodiment, the outer edges of the semiconductor wafers 17 are 7 mm separated away from the outer edge of the work plate 16, the present invention can be applied to the case, in which a distance between the outer edges of the semiconductor wafers 17 and the outer edge of the work plate 16 is less than 7 mm, etc..

Fig. 5 is an explanation view showing a sectional shape of a jet form of the high pressure water 31a.

In the present embodiment, an outlet of the jet nozzle 31 is designed to make the sectional shape of the jet form of the high pressure water 31a is longer in the direction "B" of moving the arm 22. Namely, the sectional shape of the jet form of the high pressure water 31a is shown in Fig. 5 as a black long ellipse. The outlet of the jet nozzle 31 is also formed into a long elliptic shape.

Since the jet form is formed into the long ellipse whose long axis is extended in the direction "B", the high pressure water 31a can be jetted to one point on the polishing cloth 12a for a long time, so that the part in the vicinity of the center roller 14, which cannot be fully cleaned by the conventional means, can be fully cleaned.

Note that, the sectional shape of the jet form of the high pressure water 31a is not limited to the long ellipse, it may be a circle, etc..

In the first embodiment, as shown in Fig. 5, the jet form is formed into the long ellipse whose long axis is extended in the direction "B", so the plastic nets 42 and the holding member 41 are also long in the direction "B". In this case, corners of the plastic nets 42 and the holding member 41 are rounded, the plastic nets 42 and the holding member 41 are not interfered by the center roller when the arm 22 is swung. With this structure, the plastic nets 42, the holding member 41 and the jet nozzle 31 can be moved further close to the center roller 14.

Preferably, an inclination angle of the jet nozzle 31, with respect to the vertical line from the polishing cloth 12a, is about 10° .

If the inclination angle is wider, energy of the high pressure water 31a colliding with the polishing cloth 12a is decreased.

Note that, if the angle of the jet nozzle 31 is changed between a first angle, at which the jet nozzle 31 is headed toward the center roller 14, and a second angle, at which the jet nozzle 31 is vertical with respect to the polishing cloth 12a, the polishing cloth 12a can be effectively cleaned.

To change the angle of the jet nozzle, the jet nozzle 31 is, for example, rotatably attached to a shaft and is moved between two points corresponding to said first and second angles by a cylinder unit or a motor.

In the case of changing the angle of the jet nozzle 31, the sensor 34 detects the rotational angle of the arm 22, then the jet nozzle 31 is inclined to clean the periphery of the center roller 14 if the jet nozzle 31 is located near the center roller 14. On the other hand, the jet nozzle 31 is made vertical to the polishing cloth 12a if the jet nozzle 31 is located far from the center roller 14. With this control, the polishing cloth 12a can be efficiently cleaned.

The structure of the enclosing member 40 is not limited to the plastic nets 42. For example, a cylindrical brush, which encloses the jet nozzle 31, may be employed as the enclosing member 40.

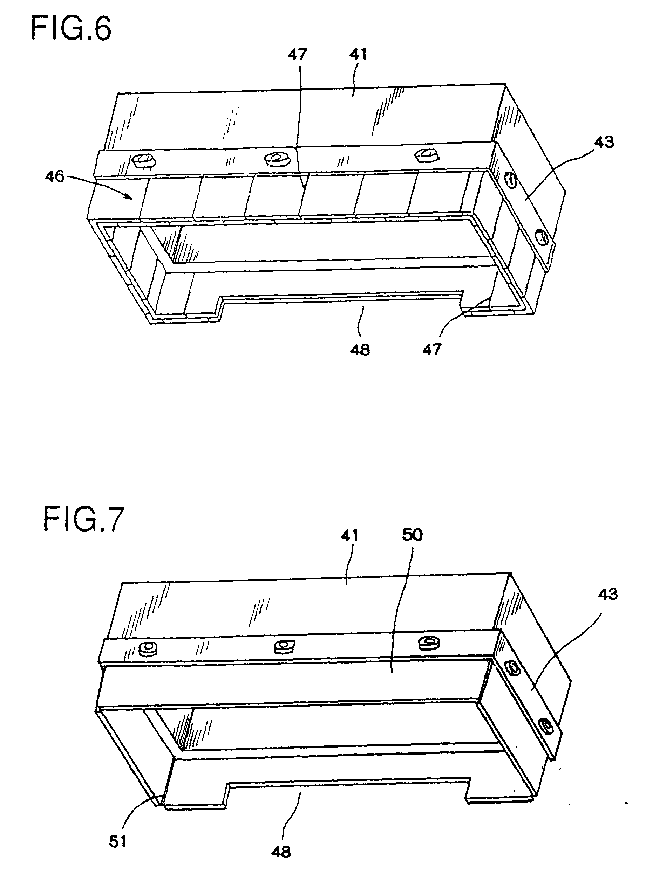

A second embodiment is shown in Fig. 6, which is a perspective view of another enclosing member.

In the second embodiment, a plurality of pieces of curtain-shaped cloth 46, whose material is equal to that of the polishing cloth 12a, are fixed to the holding member 41 instead of the plastic nets 42. Inner cloth 46 and outer cloth 46, which are made of the same material and have the same size, are piled. They are sandwiched, by bolts, between the holding member 41 and the frame-shaped member 43.

Slits 47 of the inner cloth 46 and slits of the outer cloth 46 are not corresponded. With this structure, the curtain-shaped cloth 46 wholly has proper flexibility.

A passage 48 is formed in a lower end section of a rear part of the curtain-shaped cloth 46 so as to introduce the high pressure water outside.

In the second embodiment too, the abraded grains and reaction products, which have been deposited in the polishing cloth 12a, are washed away by the high pressure water 31a. The water including the grains and the reaction products is introduced onto the polishing cloth 12a via the passage 48 and the slits 47.

Since the high pressure water jetted from the nozzle 31 collides with the inner face of the curtain-shaped cloth 46, the pressure of the high pressure water is decreased, so that the water including the reaction products, etc. cannot be scattered to the periphery. The periphery can be kept clean.

The inner cloth 46 and the outer cloth 46 are made of the same material, so mutual abrasion can be prevented.

Note that, no passage 48 may be omitted. Number, size, etc. of each piece of the curtain-shaped cloth 46 may be optionally designed according to conditions, e.g., the pressure of the high pressure water.

A third embodiment is shown in Fig. 7, which is a perspective view of another enclosing member.

In the third embodiment, four pieces of curtain-shaped cloth 50, whose material is equal to that of the polishing cloth 12a, are fixed to the holding member 41 instead of the plastic nets 42. They are sandwiched, by bolts, between the holding member 41 and the frame-shaped member 43.

Each piece of the curtain-shaped cloth 50 is provided to each side of the present enclosing member. Slits 51 are respectively formed at corners, so that the curtain-shaped cloth 50 has proper flexibility. The passage 48 is formed in a lower end section of a rear part of the curtain-shaped cloth 50 so as to introduce the high pressure water outside. In the third embodiment too, the passage 48 may be omitted.

The action of the enclosing member of the third embodiment is almost equal to that of the second embodiment (Fig. 6), so explanation will be omitted.

In the above described embodiments, the jet nozzle 31 and the enclosing member 40 are moved by the arm 22. But the present invention is not limited to the embodiments. Any other means, which is capable of moving the jet nozzle 31 and the enclosing member 40, in a plane parallel to the polishing cloth 12a, between the first position, which is located above the polishing cloth 12a, and the second position, which is located outside of the polishing cloth 12a, can be employed instead of the arm 22.

For example, an elongated arm, which is linearly and reciprocally moved, may be employed instead of the arm 22. The elongated arm may be linearly moved along a linear guide, which is provided outside of the polishing plate 12 and guides the elongated arm in the radial direction of the polishing plate 12, so as to move close to and away from the center roller 14. The elongated arm may be driven by, for example, a driving mechanism including a ball screw or a chain-sprocket unit and a servo motor. By using the servo motor, the elongated arm can be positioned at the first and the second positions.

In the case of employing the elongated arm too, the jet nozzle 31 can be properly moved close to the center roller 14 as well as the swing able arm 22. Further, if the jet nozzle 31 is inclined and the lower end of the jet nozzle 31 is headed toward the center roller 14, the high pressure water can be jetted toward the part of the polishing cloth 12a, which is in the vicinity of the center roller 14, so that the polishing cloth 12a can be properly cleaned.

In the above described embodiments, the semiconductor wafers 17 are polished as the work pieces. The work pieces are, of course, not limited to the semiconductor wafers.

In the polishing machine of the present invention, the polishing cloth including the part in the vicinity of the center roller can be fully cleaned, so that the work piece can be precisely polished with higher polishing efficiency and span of life of the expensive polishing cloth can be made longer.

## Claims

1. A polishing machine (10) comprising
a polishing plate (12) whose upper face is covered with a polishing cloth (12a);
a driving mechanism for rotating said polishing plate (12);
a center roller (14) at the center of said polishing plate (12);
a work plate (16) on which, in use, a work piece (17) to be polished is adhered and whose outer circumferential face contacts an outer circumferential face of said center roller (14), said work plate (16) being disposed relative to said polishing cloth (12a) so as to make the work piece (17) contact said polishing cloth (12a);
a press head (20) for pressing work plate (16) onto said polishing cloth (12a);
a slurry feeding mechanism (15) for feeding slurry to said polishing cloth (12a) ; **characterized by**
an arm (22) which is movable, in a plane parallel to said polishing cloth (12a) between a first position, which is located above said polishing cloth (12a), and a
second position, which is located outside of said polishing cloth (12a);
a jet nozzle (31) attached to said arm (22) for jetting high pressure water (31a) toward said polishing cloth (12); and
an enclosing member (40) enclosing said jet nozzle (31) so as to prevent the high pressure water (31a) which has been jetted out from said jet nozzle (31) from scattering;
wherein said jet nozzle (31) is disposed or disposable at an angle to the vertical and, when the arm (22) is in its first position, the jet nozzle (31) is close to the center roller (14), and the angling of the jet nozzle (31) enables high pressure water (31a) to be jetted toward a part of said polishing cloth (12a) in the vicinity of said center roller (14).

2. The polishing machine (10) according to claim 1
further comprising a guide roller (18) provided in the vicinity of an outer edge of said polishing plate (12), and
wherein an outer circumferential face of said work plate (16) contacts outer circumferential faces of said center roller (14) and said guide roller (18).

3. The polishing machine 10 according to claim 1, or claim 2,
wherein an angle of said jet nozzle (31) is variable between a first angle, which is said angle to the vertical, and a second angle, at which said jet nozzle (31) is vertical.

4. The polishing machine 10 according to any one of claims 1 to 3
wherein said jet nozzle (31) is such that a sectional shape of a jet form of the high pressure water (31a) is longer in the direction of moving said arm (22).

5. The polishing machine (10) according to any preceding claim wherein said enclosing member (40) has a lower portion enclosing said jet nozzle (31) formed of plastic net (42), a cylindrical brush, or portions of cloth (46;50) of the same material as the polishing cloth (12).

6. The polishing machine (10) according to claim 5 wherein said lower portion is a plastic net (42).

7. The polishing machine according to claim 6 wherein when the arm (22) moves to its first position, the plastic net (42) is closely adjacent the outer circumferential face of the center roller (14).

8. The polishing machine according to claims 5, 6 or 7 wherein the angled jet nozzle (31) is arranged to jet water toward the lower end of the inner face of said lower portion (42;46;50) of the enclosing member (40).

## Patentansprüche

1. Poliermaschine (10), umfassend
eine Polierplatte (12), deren obere Fläche mit einem Poliertuch (12a) bedeckt ist,
einen Antriebsmechanismus zum Drehen der Polierplatte (12),
eine mittlere Rolle (14) im Mittelpunkt der Polierplatte (12),
eine Bearbeitungsplatte (16), auf der, in Verwendung, ein zu polierender Bearbeitungsgegenstand (17) angehaftet ist und deren Außenumfangsfläche eine Außenumfangsfläche der mittleren Rolle (14) berührt, wobei die Bearbeitungsplatte (16) relativ zum Poliertuch (12a) angeordnet ist, um den Bearbeitungsgegenstand (17) mit dem Poliertuch (12a) in Kontakt zu bringen,
einen Presskopf (20) zum Pressen der Bearbeitungsplatte (16) auf das Poliertuch (12a),
einen Aufschlämmungszuführmechanismus (15) zum Zuführen von Aufschlämmung an das Poliertuch (12a), **gekennzeichnet durch**
einen Schenkel (22), der in einer zum Poliertuch (12a) parallelen Ebene zwischen einer ersten Position, die sich oberhalb des Poliertuchs (12a) befindet, und einer zweiten Position, die sich außerhalb des Poliertuchs (12a) befindet, bewegbar ist,
eine Strahldüse (31), die zum Ausstoßen eines Hochdruckwasserstrahls (31 a) in Richtung des Poliertuchs (12a) an dem Schenkel (22) befestigt ist, und
ein Umfassungselement (40) zum Einfassen der Strahldüse (31), um das Streuen des Hochdruckwasserstrahls (31 a), der von der Strahldüse (31) ausgestoßen worden ist, zu verhindern,
wobei die Strahldüse (31) in einem Winkel zur Senkrechten angeordnet oder anordenbar ist und, wenn der Schenkel (22) in seiner ersten Position ist, die Strahldüse (31) nahe der mittleren Rolle (14) ist und die Winkelstellung der Strahldüse (31) das Ausstoßen des Hochdruckwasserstrahls (31a) in Richtung eines Teils des Poliertuchs (12a) in der Umgebung der mittleren Rolle (14) ermöglicht.

2. Poliermaschine (10) nach Anspruch 1, ferner umfassend eine Führungsrolle (18), die in der Nähe einer Außenkante der Polierplatte (12) bereitgestellt ist, und
worin eine Außenumfangsfläche der Bearbeitungsplatte (16) die Außenumfangsflächen der mittleren Rolle (14)-und der Führungsrolle (18) berührt.

3. Poliermaschine 10 nach Anspruch 1 oder Anspruch 2,
worin der Winkel der Strahldüse (31) zwischen einem ersten Winkel, der der Winkel zur Senkrechten ist, und einem zweiten Winkel, an dem die Strahldüse (31) senkrecht ist, veränderbar ist.

4. Poliermaschine 10 nach einem der Ansprüche 1 bis 3,
worin die Strahldüse (31) derart ist, dass eine Querschnittform einer Strahlform des Hochdruckwasserstrahls (31 a) in der Richtung des beweglichen Schenkels (22) länger ist.

5. Poliermaschine (10) nach einem der vorangegangenen Ansprüche, worin das Umfassungselement (40) einen unteren Abschnitt zum Umfassen der Strahldüse (31) aufweist, die aus einem Kunststoffnetz (42), einer zylinderförmigen Bürste oder Tuchabschnitten (46; 50) aus dem gleichen Material wie das Poliertuch (12) ausgebildet ist.

6. Poliermaschine (10) nach Anspruch 5, worin der untere Abschnitt ein Kunststoffnetz (42) ist.

7. Poliermaschine nach Anspruch 6, worin, wenn sich der Schenkel (22) in seine erste Position bewegt, das Kunststoffnetz (42) nahe an die Außenumfangsfläche der mittleren Rolle (14) angrenzend ist.

8. Poliermaschine nach den Ansprüchen 5, 6 oder 7, worin die winkelige Strahldüse (31) angeordnet ist, um Düsenwasser in Richtung des unteren Endes der Innenfläche des unteren Abschnitts (42; 46; 50) des Umfassungselements (40) auszustoßen.

## Revendications

1. Machine de polissage (10) comprenant :
une plaque de polissage (12) dont la face supérieure est recouverte d'un tissu de polissage (12a) ;
un mécanisme d'entraînement pour faire tourner ladite plaque de polissage (12);
un rouleau central (14) au centre de ladite plaque de polissage (12) ;
une plaque de travail (16) sur laquelle, en cours d'utilisation, une pièce (17) à polir adhère, et dont la face circonférentielle extérieure vient en contact avec une face circonférentielle extérieure dudit rouleau central (14), ladite plaque de travail (16) étant disposée relativement audit tissu de polissage (12a) de façon à amener la pièce (17) à venir en contact avec ledit tissu de polissage (12a);
une tête de pression (20) pour presser la plaque de travail (16) sur ledit tissu de polissage (12a) ;
un mécanisme d'amenée de suspension épaisse (15) pour amener une suspension épaisse audit tissu de polissage (12a) ; **caractérisée par**
un bras (22) qui est déplaçable, dans un plan parallèle audit tissu de polissage (12a) entre une première position, qui se trouve au-dessus dudit tissu de polissage (12a), et une seconde position qui se situe à l'extérieur dudit tissu de polissage (12a) ;
une buse à jet (31) fixée audit bras (22) pour projeter de l'eau sous haute pression (31a) vers ledit tissu de polissage (12) ; et
un élément d'enfermement (40) enfermant ladite buse à jet (31) pour empêcher que l'eau sous haute pression (31a) qui a été expulsée de ladite buse à jet (31) se disperse ;
où ladite buse à jet (31) est disposée ou peut être disposée selon un angle à la verticale et, lorsque le bras (22) se trouve dans sa première position, la buse à jet (31) est proche du rouleau central (14), et l'angle de la buse à jet (31) permet que l'eau sous haute pression (31a) soit projetée vers une partie dudit tissu de polissage (12a) au voisinage dudit rouleau central (14).

2. Machine de polissage (10) selon la revendication 1, comprenant en outre un rouleau de guidage (18) réalisé au voisinage d'un bord extérieur de ladite plaque de polissage (12), et
où une face circonférentielle extérieure de ladite plaque de travail (16) vient en contact avec des faces circonférentielles extérieures dudit rouleau central (14) et dudit rouleau de guidage (18).

3. Machine de polissage (10) selon la revendication 1 ou la revendication 2, où un angle de ladite buse à jet (31) est variable entre un premier angle, qui est ledit angle à la verticale, et un second angle auquel ladite buse à jet (31) est verticale.

4. Machine de polissage (10) selon l'une des revendications 1 à 3, où ladite buse à jet (31) est telle qu'une forme en section d'une forme de jet de l'eau sous haute pression (31a) est plus longue dans la direction du déplacement dudit bras (22).

5. Machine de polissage (10) selon l'une des revendications précédentes, où ledit élément d'enfermement (40) présente une portion inférieure enfermant ladite buse à jet (31) formée par un filet plastique (42), une brosse cylindrique ou des portions de tissu (46 ; 50) dans le même matériau que le tissu de polissage (12).

6. Machine de polissage (10) selon la revendication 5, où ladite portion inférieure est un filet plastique (42).

7. Machine de polissage selon la revendication 6, où lorsque le bras (22) rejoint sa première position, le filet plastique (42) est étroitement adjacent à la face circonférentielle extérieure du rouleau central (14).

8. Machine de polissage selon les revendications 5, 6 ou 7, où la buse à jet angulaire (31) est agencée pour projeter l'eau vers l'extrémité inférieure de la face intérieure de ladite portion inférieure (42 ; 46 ; 50) de l'élément d'enfermement (40).
